# EUROPEAN PATENT APPLICATION

(11) **EP 3 964 402 A1**
(43) Date of publication of application: **09.03.2022**
(21) Application number: 21194774.2
(22) Date of filing: 03.09.2021
(51) Int. Cl.: B60R 16/023, H05K 7/14

(54) **ON-BOARD CABINET, AUTONOMOUS DRIVING DEVICE, AND VEHICLE**

(30) Priority: 08.09.2020 CN 202021942451 U
(71) Applicant: Beijing Tusen Zhitu Technology Co., Ltd., Beijing 100016 (CN)
(72) Inventor: WEN, Bo, Beijing, 100016 (CN); WANG, Haifeng, Beijing, 100016 (CN); YUAN, Xiaolei, Beijing, 100016 (CN); JIA, Ruifang, Beijing, 100016 (CN); WANG, Yajia, Beijing, 100016 (CN); SUN, Ming, Beijing, 100016 (CN); HAO, Jianan, Beijing, 100016 (CN)
(74) Representative: Murgitroyd & Company

(57) **Abstract**

The present disclosure provides an on-board cabinet, an autonomous driving device, and a vehicle. The on-board cabinet includes a cabinet body, at least one shock absorbing assembly, and at least one carrier plate. The cabinet body includes an interior providing a space for accommodating, and the shock absorbing assembly and the carrier plate are disposed inside the cabinet body. The shock absorbing assembly includes an adjusting plate and an elastic element, the adjusting plate is vertically disposed inside the cabinet body by the elastic element, and the carrier plate is movably disposed on the adjusting plate.

## Description

### TECHNICAL FIELD

The present document relates to the technology field of on-board equipment and in particular to an on-board cabinet, an autonomous driving device, and a vehicle.

### BACKGROUND

Road transportations occupy a very important status in logistics systems, especially in China, nearly eighty percent of cargo transportation is completed by road transportation. In road transportation, labor intensity of driving trucks is high, so there is a practical demand for driverless technology. The driverless technology includes installation of various types of sensors on truck bodywork and the use of the sensors to perceive a driving environment around driverless vehicles (i.e., autonomous vehicles). Driverless equipment includes lidars, camera combinations, accurate GPS positioners, millimeter wave radars, AI (artificial intelligence) computing terminals, image processors, servers, etc.

A good environment is required to operate driverless equipment and a stable platform is required to arrange these hardware and software vectors. The sensors, such as the lidars, the cameras, the millimeter wave radars, the GPS positioners, etc., in the vehicles are usually installed through various stable sensor brackets. However, for the AI computing terminals, the image processors, the on-board servers, and other driverless devices, there is no structural solution that can safely and stably carry and support installation of the driverless equipment in the vehicles.

### SUMMARY

Therefore, described herein are embodiments of an on-board cabinet, an autonomous driving device, and a vehicle that solve the problem of poor performance of shock absorption of the existing on-board brackets.

In an aspect, some embodiments provide an on-board cabinet, including a cabinet body, at least one shock absorbing assembly, and at least one carrier plate, in which the cabinet body includes an internal accommodate space (e.g., an internal space for computing component installation), and the shock absorbing assembly and the carrier plate are disposed inside the cabinet body, the shock absorbing assembly includes adjusting plates and elastic elements, the adjusting plates are vertically disposed inside the cabinet body by the elastic elements, and the carrier plate is movably disposed on the adjusting plates.

According to an aspect of the embodiments, the cabinet body includes vertical columns, first connecting beams, and second connecting beams connected to each other; the cabinet body includes a plurality of the vertical columns, the plurality of the vertical columns are arranged at intervals and arranged in two rows, and the vertical columns in each row are arranged along a first direction; the first connecting beams are arranged on upper parts and lower parts of the vertical columns along the first direction, so that the vertical columns in a same row are connected into a whole, the second connecting beams are arranged between the two rows of the vertical columns along a second direction, so that the vertical columns in the two rows are connected into a whole.

According to an aspect of the embodiments, two ends of each of the second connecting beams are respectively connected to the first connecting beams on the two rows of the vertical columns.

According to an aspect of the embodiments, the elastic elements are vertically disposed on the cabinet body, the adjusting plates are connected to the cabinet body by the elastic elements, the adjusting plates can move vertically relative to the cabinet body, and the adjusting plates can be close to or away from the cabinet body.

According to an aspect of the embodiments, the cabinet body defines a plurality of positioning holes arranged vertically, and the elastic elements are connected to the cabinet body through the positioning holes.

According to an aspect of the embodiments, the on-board cabinet includes a plurality of carrier plates, and the plurality of the carrier plates are sequentially arranged inside the cabinet body along a first direction.

According to an aspect of the embodiments, the on-board cabinet includes a plurality of shock absorbing assemblies, and the plurality of the shock absorbing assemblies are sequentially arranged on the cabinet body along a periphery of the carrier plate.

According to an aspect of the embodiments, an inner bottom of the cabinet body is provided with elastic supports, and the elastic supports are configured to support the carrier plate close to the bottom of the cabinet body.

According to an aspect of the embodiments, sliding rails extending in a first direction are disposed on the adjusting plates, the carrier plate is connected to the sliding rails, and the carrier plate can slide relative to the sliding rails.

In another aspect, embodiments provide an autonomous driving device, including the aforementioned on-board cabinet.

In another aspect, embodiments provide a vehicle, including the aforementioned autonomous driving device.

In some on-board cabinet provided by the embodiments, the carrier plates are disposed on the adjusting plates, the adjusting plates are vertically disposed on the cabinet body by the elastic elements, the elastic elements can filter vibration to reduce an impact of the vibration on the carrier plates, thereby reducing an impact of the vibration on the equipment carried by the carrier plates. The servers, various sensors, camera combinations, and other on-board devices may be installed on the carrier plates, when bumps and large-scale shaking occur during the driving of the vehicle, the impact can be effectively filtered to ensure that the equipment carried by the carrier plates can operate stably, which is conducive to stability and accuracy of the equipment, and the problem of poor shock absorption performance of the existing on-board brackets can thus be solved.

An aspect of the disclosed embodiments relates to an on-board cabinet that includes a cabinet body comprising an internal space. The on-board cabinet further includes a shock absorbing assembly disposed in the internal space, the shock absorbing assembly comprising an adjusting plate and an elastic element. The on-board cabinet also includes a carrier plate disposed in the internal space. In the on-board cabinet, the adjusting plate is vertically disposed in the internal space by the elastic element, and the carrier plate is movably disposed on the adjusting plate.

Another aspect of the disclosed embodiments relates to an autonomous driving device that includes an on-board cabinet comprising a cabinet body that includes an internal space. The on-board cabinet further includes a shock absorbing assembly disposed in the internal space, the shock absorbing assembly comprising an adjusting plate and an elastic element. The on-board cabinet also includes a carrier plate disposed in the internal space. In the on-board cabinet, the adjusting plate is vertically disposed in the internal space by the elastic element, and the carrier plate is movably disposed on the adjusting plate.

An aspect of the disclosed embodiments relates to a vehicle, including the aforementioned autonomous driving device.

Yet another aspect of the disclosed embodiments relates to a method that includes providing a cabinet body comprising an internal space. The method also includes providing a shock absorbing assembly disposed in the internal space, the shock absorbing assembly comprising an adjusting plate and an elastic element. The method further includes providing a carrier plate disposed in the internal space. According to the method, the adjusting plate is vertically disposed in the internal space by the elastic element, and the carrier plate is movably disposed on the adjusting plate.

### BRIEF DESCRIPTION OF THE DRAWINGS

In order to explain the technical solutions in the embodiments more clearly, the following will introduce briefly the drawings used in the description of the embodiments. Obviously, the drawings in the following description are merely several embodiments of the present disclosure. For those skilled in the art, other drawings can be obtained based on these drawings without creative work.
FIG. 1 is a schematic view of a stereoscopic structure of an on-board cabinet of an embodiment of the present disclosure.
FIG. 2 is a schematic view of a front view structure of the on-board cabinet of the embodiment of the present disclosure.
FIG. 3 is a schematic view of a top view structure of the on-board cabinet of the embodiment of the present disclosure.
FIG. 4 is a partial schematic view of the stereoscopic structure of the on-board cabinet of the embodiment of the present disclosure.
FIG. 5 is a partial schematic view of the front view structure of the on-board cabinet of the embodiment of the present disclosure.
FIG. 6 shows a schematic diagram of an autonomous driving system according to the disclosed technology.
FIG. 7 shows a flow diagram of an example embodiment of a method according to the disclosed technology.

### DETAILED DESCRIPTION

Implementations will be described in further detail below with reference to the drawings and embodiments. The detailed description of the following embodiments and drawings are used to exemplarily illustrate principles of the present disclosure, but cannot be used to limit the scope of the present disclosure, that is, the present disclosure is not limited to the described embodiments.

In description of the present disclosure, it should be noted, the terms "first" and "second" are used herein for purposes of description, and should not be interpreted as indication or implication of relative importance, the terms "a plurality of' means two or more than two, and orientation or position relations represented by directional terms, such as "inner", or "outer", "top", "bottom", etc. are orientation or position relations based on illustration of the drawings, merely for the convenience of describing the present disclosure and simplifying the description, rather than indicating or implying that the device or element is intended to have a particular orientation, or is constructed and operated in a particular orientation and therefore should not be interpreted as a limitation of the present disclosure.

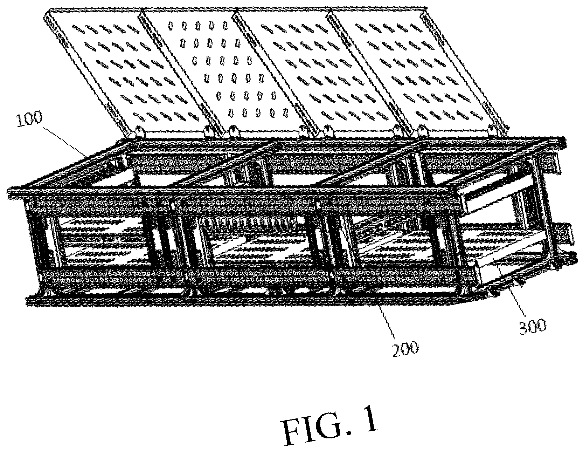

In FIGS. 1-5:
cabinet body 100; shock absorbing assembly 200; carrier plate 300; elastic support 400; first connecting beam 101; second connecting beam 102; vertical column 103; wire box 104; wire slot 105; adjusting plate 201; elastic element 202; positioning hole 205; sliding rail 301; computing unit 550; strong current area A1; server area A2; weak current area A3.

Autonomous driving systems (also referred to as driverless vehicles, autonomous driving vehicles, autonomous vehicles, or self-driving vehicles) should safely and reliably accommodate all types of road configurations and conditions. The road conditions can include, for example, conditions of the road surface of a paved or an unpaved road such as, for example, size and extent of potholes or bumps on the road, extent of presence and size of the objects on the road such as small rocks, gravel, debris, etc. The road conditions can also include weather conditions such as rain, snow, wind, dust storms, extreme temperatures, etc. Different road conditions can lead to different degrees of vibrational exposure and mechanical shock exposure of an autonomous vehicle. On-board equipment of the autonomous vehicle such as, e.g., an in-vehicle control computer, an autonomous control unit, or a navigation unit of the autonomous vehicle should function in an uninterrupted and reliable manner under any such road conditions.

A sheet metal bracket is typically used for carrying and installing the AI (artificial intelligence) computing terminals, the image processors, the on-board servers, and other devices in a vehicle. These sheet metal brackets may be arranged in multiple layers to accommodate different equipment and wire harness layouts. However, this solution has many shortcomings, such as poor shock absorption performance, which has a great impact on servers and other vibration-sensitive devices. Therefore, it is necessary to design a professional carrying device to install the driverless equipment.

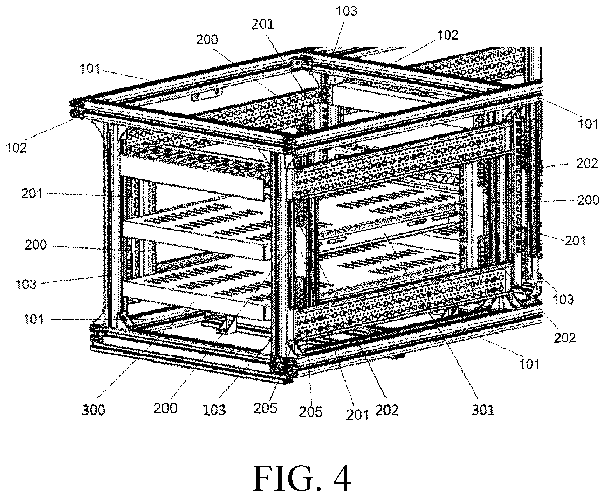

To accomplish this, among other uses, referring to FIG.1 and FIG. 4, an on-board cabinet of an embodiment of the present disclosure includes a cabinet body 100, at least one shock absorbing assembly 200, and at least one carrier plate 300. The cabinet body 100 includes an internal accommodate space (e.g., an internal space for computing component installation), and the shock absorbing assembly 200 and the carrier plate 300 are disposed inside the cabinet body 100. The shock absorbing assembly 200 includes adjusting plates 201 and elastic elements 202, the adjusting plates 201 are vertically disposed inside the cabinet body 100 by the elastic elements 202, and the carrier plate 300 is movably disposed on the adjusting plates 201. In the embodiment, the carrier plate 300 is disposed on the adjusting plates 201, and the adjusting plates 201 are vertically disposed on the cabinet body 100 by the elastic elements 202, so the elastic elements 202 can filter vibration to reduce an impact of the vibration on the carrier plate 300, thereby reducing an impact of the vibration on the equipment carried by the carrier plate 300. The on-board servers, switches, small power supplies, and other on-board devices can be installed on the carrier plate 300, when bumps and large-scale shaking occur during the driving of the vehicle, the impact can be effectively filtered to ensure that the equipment carried by the carrier plate 300 can operate stably, which is conducive to stability and accuracy of the equipment.

The equipment that can be installed on the carrier plate 300 inside the cabinet body 100 includes but is not limited to the driverless equipment, and may specifically include on-board servers, switches, small power supplies, etc., wherein the on-board servers (or on-board computer) can be provided with one or two (redundant design). The on-board cabinet of the embodiment can provide a stable platform for the arrangement of the above-mentioned equipment and provide a good environment for operation.

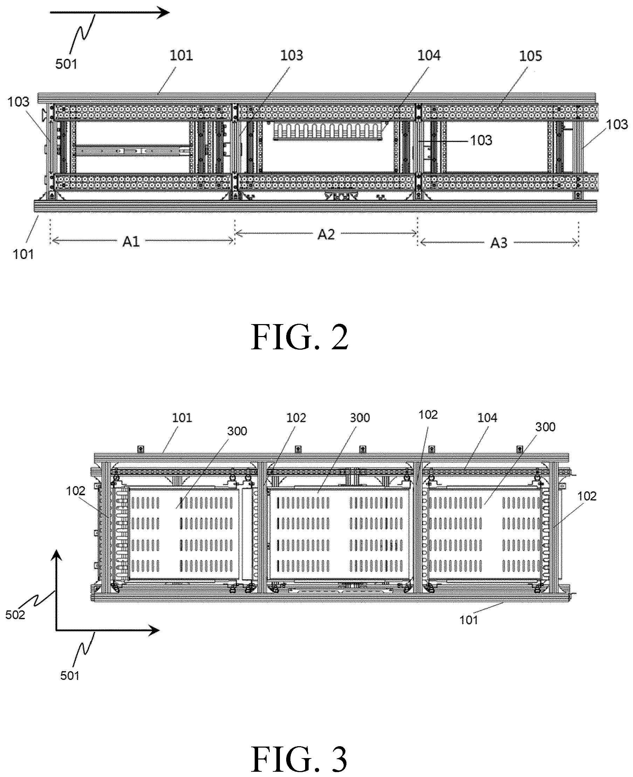

Referring to FIG. 2 and FIG. 3 in conjunction, in an optional embodiment, the cabinet body 100 includes vertical columns 103, first connecting beams 101, and second connecting beams 102 connected to each other. The cabinet body 100 includes a plurality of vertical columns 103, the plurality of vertical columns 103 are arranged at intervals and arranged in two rows, and the vertical columns 103 in each row are arranged along a first direction (e.g., along the direction indicated by the arrow 501 in FIGS. 2 and 3). The first connecting beams 101 are arranged on upper and lower parts of the vertical columns 103 along the first direction so that the vertical columns 103 in a same row are connected into a whole. The second connecting beams 102 are arranged between the two rows of the vertical columns 103 along a second direction (e.g., along the direction indicated by the arrow 502 in FIG. 3) so that the vertical columns 103 in the two rows are connected into a whole.

In the embodiment, the plurality of vertical columns 103 are arranged in two rows, the first connecting beams 101 connect the vertical columns 103 in a same row by the upper and lower parts of the vertical columns 103 into a whole, that is, the upper parts of the vertical columns 103 in a same row are successively connected by one of the first connecting beams 101, and the lower parts of the vertical columns 103 in a same row are successively connected by another one of the first connecting beams 101, the vertical columns 103 in a same row are connected by two of the first connecting beams 101 into a whole, and then the vertical columns 103 in the two rows are connected by the second connecting beams 102 into a whole. The vertical columns 103, the first connecting beams 101, and the second connecting beams 102 cooperate to form a space frame structure, the overall structure is stable and is an open structure, which facilitates an installation of the carrier plate 300 and other components inside the space frame structure. It also facilitates an arrangement of various vertical equipment.

In an optional embodiment, two ends of the second connecting beam 102 are respectively connected to the first connecting beams 101 on the two rows of the vertical columns 103.

In the embodiment, first ends of one part of the second connecting beams 102 are connected to the first connecting beam 101 on the upper parts of the vertical columns 103 in a first row, and second ends of the part of the second connecting beams 102 are connected to the first connecting beam 101 on the upper parts of the vertical columns 103 in a second row, at the same time, first ends of the other part of the second connecting beams 102 are connected to the first connecting beam 101 on the lower parts of the vertical columns 103 in the first row, and second ends of the other part of the second connecting beams 102 are connected to the first connecting beam 101 on the lower parts of the vertical columns 103 in the second row. That is, the second connecting beams 102 are horizontally connected between the upper parts and the lower parts of the two rows of the vertical columns 103.

Alternatively, the first ends of the second connecting beams 102 are connected to the first connecting beam 101 on the upper parts of the vertical columns 103 in the first row, and the second ends of the second connecting beams 102 are connected to the first connecting beam 101 on the lower parts of the vertical columns 103 in the second row. That is, the second connecting beams 102 are tilted and connected between the two rows of the vertical columns 103. Furthermore, the adjacent second connecting beams 102 may be arranged crosswise in the first direction.

That is, the two rows of the vertical columns 103 are connected to each other through the second connecting beams 102, and the upper and lower parts of the corresponding vertical columns 103 are connected to the second connecting beams 102.

In an optional embodiment, the elastic elements 202 are vertically disposed on the cabinet body 100, the adjusting plates 201 are connected to the cabinet body 100 by the elastic elements 202, the adjusting plates 201 can move vertically relative to the cabinet body 100, and the adjusting plates 201 can be close to or away from the cabinet body 100.

In the embodiment, the adjusting plates 201 are connected to the cabinet body 100 by the elastic elements 202, the elastic elements 202 are vertically disposed on the cabinet body 100, the adjusting plates 201 can move vertically relative to the cabinet body 100, at the same time, the elastic elements 202 also have a certain degree of expansion and contraction margin in lateral and oblique directions, so the adjustment plates 201 and the elastic elements 202 can cooperate to realize a three-dimensional shock absorption of the carrier plates 300, that is to realize a three-dimensional shock absorption of the equipment carried by the carrier plate 300, thereby reducing the impact of vibration on the carried equipment and ensuring a stable operation of the equipment.

Specifically, upper and lower ends of the adjusting plates 201 may be connected to the cabinet body 100 by the elastic elements 202, that is, the upper and lower ends of the adjusting plates 201 are connected with the elastic elements 202. Alternatively, the upper ends of the adjusting plates 201 are hung on the cabinet body 100 by the elastic elements 202. The elastic elements 202 may be springs or other elastic elements.

In an optional embodiment, the cabinet body 100 defines a plurality of positioning holes arranged vertically, and the elastic elements 202 are connected to the cabinet body 100 through the positioning holes.

In the embodiment, the elastic elements 202 are connected to the cabinet body 100 through the positioning holes, and there is a plurality of positioning holes. On one hand, connection positions of the elastic elements 202 on the cabinet body 100 are adjustable, that is, a mounting height of the carrier plate 300 is optional or variable, which facilitates matching an assembly according to layout requirements of the on-board equipment, and has high flexibility. On the other hand, heads and tails of the elastic elements 202 can be connected to the positioning holes with different intervals, and tightness of the elastic elements 202 can be adjustable, so that a shock absorption intensity can be adjusted according to actual application situations to meet different shock absorption requirements.

In an optional embodiment, there are a plurality of carrier plates 300, and the plurality of carrier plates 300 are arranged in the cabinet body 100 along the first direction.

In the embodiment, the plurality of carrier plates 300 are spread out in a horizontal direction, and may be flush in a vertical direction, that is, at a same level, or staggered, that is, at different levels, so that the internal accommodate space, that is the internal space for computing component installation, of the cabinet body 100 is divided into different areas, which is convenient for categorizing and arranging various on-board equipment. Furthermore, one or more carrier plates 300 may also be stacked above the carrier plates 300, so that the internal space of the cabinet body 100 can be fully utilized.

When the on-board equipment in a cab (the cab is the interior portion of an autonomous vehicle such as an autonomous truck or a tractor of the autonomous truck which traditionally accommodates a space for a driver, passenger, and sleeping berth) is arranged on brackets on one side in a conventional manner, this results in a large thickness in a vertical direction of the brackets. This arrangement of brackets may result in an unstable configuration of a frame and even a vehicle body. In addition, due to the large thickness in the vertical direction of the brackets, the brackets have a high center of gravity, strength of fastening points to the vehicle body may be insufficient, and the risk of being pulled and cracked is high.

Comparatively, the plurality of carrier plates 300 of the embodiment are spread out sequentially in the horizontal direction. While making full use of the internal accommodate space (e.g., the internal space for computing component installation), of the cabinet body 100, it can carry more on-board equipment, so that the cabinet body 100 can be presented in a horizontal structure, which can effectively use the space in the cab. For example, sizes of the cabinet body 100 can be designed to match a sleeping compartment in the cab. The center of gravity of the cabinet body 100 is lower, and a weight distribution of itself and the on-board equipment can be more even, without affecting comfort. In addition, fixed points of the vehicle can be effectively used for fastening, and the installation is convenient, and strength of the fixed points is guaranteed, and the stability and reliability are better.

It is also important to note that in autonomous vehicles using sheet metal brackets to mount equipment when the arrangement of the on-board equipment on the brackets is too concentrated, there may be no distinction between the strong and weak currents of the equipment. This lack of distinction between strong and weak current equipment may cause mutual electromagnetic interference between the equipment, which can have a particularly obvious impact on some precision devices. At the same time, such a configuration can also have safety risks.

Comparatively, arrangement of the plurality of carrier plates 300 in the embodiment divides the internal accommodate space of the cabinet body 100 into different areas in the horizontal direction. For example, at least three carrier plates 300 divide the internal accommodate space of the cabinet body 100 into three areas, which in turn serve as a strong current area A1, a server area A2, and a weak current area A3, so that different needs of on-board equipment may be arranged in different areas. In this way, strong current storage, weak current storage, and server storage can be arranged to ensure that devices do not experience electromagnetic interference. This configuration is also convenient for layouts and directions of wire harnesses.

For the layouts and directions of the wire harnesses, wire boxes 104 and/or the wire slots 105 may be arranged on a front side, a rear side, an upper side, a bottom side, a left side, and/or a right side of the cabinet body 100 to reasonably plan the layouts and directions of the wire harnesses of the equipment, and to protect the wire harnesses of the equipment at the same time.

In an optional embodiment, there may be a plurality of shock absorbing assemblies 200. The plurality of shock absorbing assemblies 200 are sequentially arranged on the cabinet body 100 along peripheries of the carrier plates 300.

In the embodiment, the shock absorbing assemblies 200 arranged in sequence along the peripheries of the carrier plates 300 make the carrier plates 300 more stable and have a better shock-absorbing effect. Multiple of the shock absorbing assemblies 200 arranged along the periphery of one of the carrier plates 300 form a group. Preferably, one group of the shock absorbing assemblies 200 are evenly distributed along the periphery of the carrier plate 300. For example, if the carrier plate 300 is square or rectangular, it may be matched with a group of four shock absorbing assemblies 200, and the four shock absorbing assemblies 200 are respectively arranged corresponding to four corners of the carrier plate 300, and the shock absorption is more even.

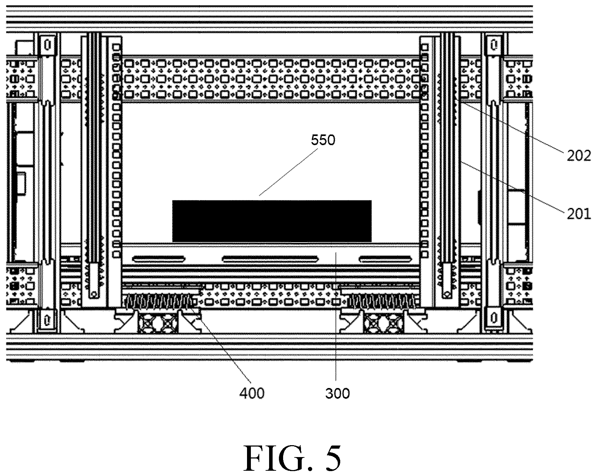

Referring to FIG. 5 in conjunction, in an optional embodiment, an inner bottom of the cabinet body 100 is provided with elastic supports 400, and the elastic supports 400 are used to support the carrier plates 300 close to the bottom of the cabinet body 100. In some implementations, a computing unit 550, such as the in-vehicle control computer, an autonomous control unit, or a navigation unit of the vehicle, may be located (e.g., installed) on a carrier plate 300 within the cabinet body 100 of an autonomous driving device that includes an on-board cabinet.

Continuing the above, two layers of the carrier plates 300 may be arranged in the strong current area A1 and the weak current area A3 on both sides, and one layer of the carrier plates 300 may be arranged in the server area A2 in middle. The stacked carrier plates 300 may be connected to a same group of shock absorbing assemblies 200, or may be connected to different groups of shock absorbing assemblies 200 that are stacked.

Since the server is heavier, or the lower carrier plates 300 need to carry more and heavier equipment, it will pre-occupy a larger part of a telescopic stroke of the elastic elements 202, so the elastic supports 400 are added to properly support above-mentioned carrier plates 300 and cooperate with the elastic elements 202 for shock absorption to ensure the shock absorption effect.

Referring to FIG. 4 in conjunction, in an optional embodiment, sliding rails 301 extending in the first direction are disposed on the adjusting plates 201, the carrier plates 300 are connected to the sliding rails 301, and the carrier plates 300 can slide relative to the sliding rails 301.

In the embodiment, the carrier plates 300 are connected to the adjusting plates 201 through the sliding rails 301, the carrier plates 300 can slide in the horizontal direction, and the carrier plates 300 can be installed on the machine body after the equipment is installed on the carrier plates 300, which facilitates the installation of the equipment. When a certain device needs to be overhauled, other surrounding components can be moved by sliding the carrier plates 300 to free up space and facilitate the overhaul of the device. It can be understood that after the equipment and the carrier plates 300 are installed, the positions of the carrier plates 300 on the sliding rails 301 may be locked.

In the embodiment, cover plates and baffles may also be provided on the cabinet body 100 to protect the equipment inside the cabinet body 100. The cover plates and the baffles are movably connected to the cabinet body 100. The cabinet body 100 is an open design as a whole, which is convenient for installation, heat dissipation, and maintenance of the equipment.

In addition, the vertical columns 103, the first connecting beams 101, and the second connecting beams 102 of the cabinet body 100 may be made of regular aluminum alloys, which are lighter in weight and easy to assemble.

Embodiments of the present disclosure further provide an autonomous driving device, including the on-board cabinet of the above-mentioned embodiments, as well as on-board servers, switches, small power supplies, and the like. The above-mentioned equipment is installed inside the cabinet body, specifically on the carrier plates 300. When bumps and large-scale shaking occur during the driving of the vehicle, the impact can be effectively filtered to ensure that the equipment carried by the carrier plates 300 can operate stably. It can also realize strong and weak current distribution of the equipment and daily protection of the equipment, which is conducive to the stability and accuracy of equipment work, and is helpful to the development of the autonomous driving technology. Embodiments of the present disclosure further provide a vehicle, including the above autonomous driving device.

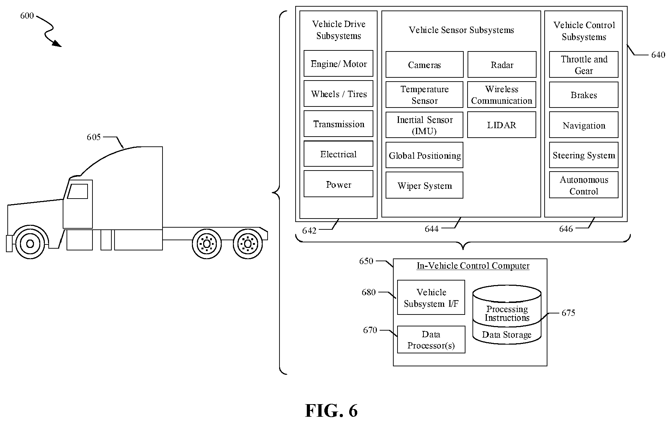

FIG. 6 shows a schematic diagram of an autonomous driving system (e.g., an autonomous driving vehicle which can be also referred to as autonomous vehicle or self-driving-vehicle) 600 according to the disclosed technology. The system 600 may include an on-board cabinet according to the disclosed technology and/or an autonomous driving device comprising an on-board cabinet according to the disclosed technology.

As shown in FIG. 6, the autonomous vehicle 605 may be a semi-trailer truck. The system 600 includes several systems and components that can generate and/or deliver one or more sources of information/data and related services to the in-vehicle control computer 650 that may be located in a vehicle 605. The in-vehicle control computer 650 can be in data communication with a plurality of vehicle subsystems 640, all of which can be resident in the vehicle 605. A vehicle subsystem interface 660 is provided to facilitate data communication between the in-vehicle control computer 650 and the plurality of vehicle subsystems 640. In some embodiments, the vehicle subsystem interface 660 can include a controller area network (CAN) controller to communicate with devices in the vehicle subsystems 640.

The vehicle 605 may include various vehicle subsystems that support of the operation of vehicle 605. The vehicle subsystems may include a vehicle drive subsystem 642, a vehicle sensor subsystem 644, and/or a vehicle control subsystem 646. The components or devices of the vehicle drive subsystem 642, the vehicle sensor subsystem 644, and the vehicle control subsystem 646 are shown as examples.

The vehicle drive subsystem 642 may include components operable to provide powered motion for the vehicle 605. In an example embodiment, the vehicle drive subsystem 642 may include an engine or motor, wheels/tires, a transmission, an electrical subsystem, and a power source.

The vehicle sensor subsystem 644 may include a number of sensors configured to sense information about an environment or condition of the vehicle 605. The vehicle sensor subsystem 644 may include one or more cameras or image capture devices, one or more temperature sensors, an inertial measurement unit (IMU), a Global Positioning System (GPS) transceiver, a laser range finder/LIDAR unit, a RADAR unit, and/or a wireless communication unit (e.g., a cellular communication transceiver). The vehicle sensor subsystem 644 may also include sensors configured to monitor internal systems of the vehicle 605 (e.g., an O₂ monitor, a fuel gauge, an engine oil temperature, etc.,).

The IMU may include any combination of sensors (e.g., accelerometers and gyroscopes) configured to sense position and orientation changes of the vehicle 605 based on inertial acceleration. The GPS transceiver may be any sensor configured to estimate a geographic location of the vehicle 605. For this purpose, the GPS transceiver may include a receiver/transmitter operable to provide information regarding the position of the vehicle 605 with respect to the Earth. The RADAR unit may represent a system that utilizes radio signals to sense objects within the local environment of the vehicle 605. In some embodiments, in addition to sensing the objects, the RADAR unit may additionally be configured to sense the speed and the heading of the objects proximate to the vehicle 605. The laser range finder or LIDAR unit may be any sensor configured to sense objects in the environment in which the vehicle 605 is located using one or more lasers. The cameras may include one or more devices configured to capture a plurality of images of the environment of the vehicle 605. The cameras may be still image cameras or motion video cameras.

The vehicle control subsystem 646 may be configured to control operation of the vehicle 605 and its components. Accordingly, the vehicle control subsystem 646 may include various elements such as a throttle and gear, a brake unit, a navigation unit, a steering system and/or an autonomous control unit. The throttle may be configured to control, for instance, the operating speed of the engine and, in turn, control the speed of the vehicle 605. The gear may be configured to control the gear selection of the transmission. The brake unit can include any combination of mechanisms configured to decelerate the vehicle 605. The brake unit can use friction to slow the wheels in a standard manner. The brake unit may include an Anti-lock brake system (ABS) that can prevent the brakes from locking up when the brakes are applied. The navigation unit may be any system configured to determine a driving path or route for the vehicle 605. The navigation unit may additionally be configured to update the driving path dynamically while the vehicle 605 is in operation. In some embodiments, the navigation unit may be configured to incorporate data from the GPS transceiver and one or more predetermined maps so as to determine the driving path for the vehicle 605. The steering system may represent any combination of mechanisms that may be operable to adjust the heading of vehicle 605 in an autonomous mode or in a driver-controlled mode.

The autonomous control unit may represent a control system configured to identify, evaluate, and avoid or otherwise negotiate potential obstacles in the environment of the vehicle 605. In general, the autonomous control unit may be configured to control the vehicle 605 for operation without a driver or to provide driver assistance in controlling the vehicle 605. In some embodiments, the autonomous control unit may be configured to incorporate data from the GPS transceiver, the RADAR, the LIDAR, the cameras, and/or other vehicle subsystems to determine the driving path or trajectory for the vehicle 605.

Many or all of the functions of the vehicle 605 can be controlled by the in-vehicle control computer 650. The in-vehicle control computer 650 may include at least one data processor 670 (which can include at least one microprocessor) that executes processing instructions stored in a non-transitory computer readable medium, such as the data storage device 675 or memory. The in-vehicle control computer 650 may also represent a plurality of computing devices that may serve to control individual components or subsystems of the vehicle 605 in a distributed fashion.

The data storage device 675 may contain additional instructions as well, including instructions to transmit data to, receive data from, interact with, or control one or more of the vehicle drive subsystem 642, the vehicle sensor subsystem 644, and the vehicle control subsystem 646. The in-vehicle control computer 650 can be configured to include a data processor 670 and a data storage device 675. The in-vehicle control computer 650 may control the function of the vehicle 605 based on inputs received from various vehicle subsystems (e.g., the vehicle drive subsystem 642, the vehicle sensor subsystem 644, and the vehicle control subsystem 646) via a vehicle subsystem interface 680.

According to some example implementations, any of the mentioned subsystems (or subsystem parts) and/or components or elements of the system 600 can be located inside an on-board cabinet according to the disclosed technology. For example, a computing unit such as, e.g., the in-vehicle control computer 650, an autonomous control unit, or a navigation unit of the vehicle 605, can be located on a carrier plate within the body of an example embodiment of on-board cabinet according to the disclosed technology.

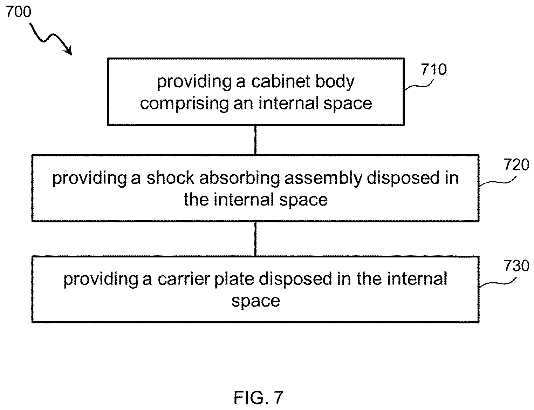

FIG. 7 shows a flow diagram of an example embodiment of a method 700 according to the disclosed technology. The method 700 includes a process 710 of providing a cabinet body comprising an internal space. The method 700 further includes a process 720 of providing a shock absorbing assembly disposed in the internal space. In certain example embodiments, the shock absorbing assembly comprises an adjusting plate and an elastic element. The method 700 also includes a process 730 of providing a carrier plate disposed in the internal space. In some example embodiments, the adjusting plate is vertically disposed in the internal space by the elastic element, and the carrier plate is movably disposed on the adjusting plate.

An aspect of the disclosed embodiments relates to an on-board cabinet, comprising a cabinet body comprising an internal space; a shock absorbing assembly disposed in the internal space, the shock absorbing assembly comprising: an adjusting plate; and an elastic element; and a carrier plate disposed in the internal space; wherein the adjusting plate is vertically disposed in the internal space by the elastic element, and the carrier plate is movably disposed on the adjusting plate.

In some example embodiments, the cabinet body comprises a plurality of vertical columns, first connecting beams, and second connecting beams connected to each other; the vertical columns are arranged at intervals and arranged in two rows; wherein the vertical columns in each row are arranged along a first direction; the first connecting beams extend along the first direction and are arranged on upper parts and lower parts of the vertical columns, so that the vertical columns in a same row are connected, and the second connecting beams extend along a second direction and are arranged between the two rows of the vertical columns, so that the vertical columns in the two rows are connected. According to some example embodiments, two ends of each of the second connecting beams are respectively connected to the first connecting beams on the two rows of vertical columns. In certain example embodiment, the elastic element is vertically disposed on the cabinet body, and the adjusting plate is connected to the cabinet body by the elastic element and is vertically movable relative to the cabinet body to get close to or away from the cabinet body. According to some example embodiments, the cabinet body comprises a plurality of positioning holes arranged vertically, and the elastic element is connected to the cabinet body through the positioning holes. In some example embodiments, the carrier plate comprises a plurality of carrier plates, and the plurality of carrier plates are sequentially arranged in the internal space along a first direction. According to certain example embodiments, the shock absorbing assembly comprises a plurality of shock absorbing assemblies, and the plurality of shock absorbing assemblies are sequentially arranged in the internal space along a periphery of the carrier plate. In some example embodiments, the cabinet body further comprises an elastic support deposed at a bottom of the cabinet body, and the elastic support being configured to support the carrier plate when the carrier plate gets close to the bottom of the cabinet body. According to some example embodiments, the cabinet body further comprises a sliding rail extending in a first direction disposed on the adjusting plate, the carrier plate being connected to the sliding rail and being movable relative to the sliding rail.

Another aspect of the disclosed embodiments relates to an autonomous driving device, comprising an on-board cabinet, the on-board cabinet comprising: a cabinet body comprising an internal space; a shock absorbing assembly disposed in the internal space, the shock absorbing assembly comprising: an adjusting plate; and an elastic element; and a carrier plate disposed in the internal space; wherein the adjusting plate is vertically disposed in the internal space by the elastic element, and the carrier plate is movably disposed on the adjusting plate.

In some example embodiments of autonomous driving device, the cabinet body comprises a plurality of vertical columns, first connecting beams, and second connecting beams connected to each other; the vertical columns are arranged at intervals and arranged in two rows; wherein the vertical columns in each row are arranged along a first direction; the first connecting beams extend along the first direction and are arranged on upper parts and lower parts of the vertical columns, so that the vertical columns in a same row are connected, and the second connecting beams extend along a second direction and are arranged between the two rows of the vertical columns, so that the vertical columns in the two rows are connected. According to certain example embodiments, two ends of each of the second connecting beams are respectively connected to the first connecting beams on the two rows of vertical columns. In some example embodiments, the elastic element is vertically disposed on the cabinet body, and the adjusting plate is connected to the cabinet body by the elastic element and is vertically movable relative to the cabinet body to get close to or away from the cabinet body. According to some example embodiments, the cabinet body comprises a plurality of positioning holes arranged vertically, and the elastic element is connected to the cabinet body through the positioning holes. In certain example embodiments, the carrier plate comprises a plurality of carrier plates, and the plurality of carrier plates are sequentially arranged in the internal space along a first direction. According to some example embodiments, the shock absorbing assembly comprises a plurality of shock absorbing assemblies, and the plurality of shock absorbing assemblies are sequentially arranged in the internal space along a periphery of the carrier plate. In certain example embodiments, the autonomous driving device further comprises an elastic support deposed at a bottom of the cabinet body, and the elastic support being configured to support the carrier plate when the carrier plate gets close to the bottom of the cabinet body. According to some example embodiments, the autonomous driving device further comprises a sliding rail extending in a first direction disposed on the adjusting plate, the carrier plate being connected to the sliding rail and being movable relative to the sliding rail.

Yet another aspect of the disclosed embodiments relates to a vehicle, comprising an autonomous driving device comprising an on-board cabinet, the on-board cabinet comprising: a cabinet body comprising an internal space; a shock absorbing assembly disposed in the internal space, the shock absorbing assembly comprising: an adjusting plate; and an elastic element; and a carrier plate disposed in the internal space; wherein the adjusting plate is vertically disposed in the internal space by the elastic element, and the carrier plate is movably disposed on the adjusting plate.

An aspect of the disclosed embodiments relates to an autonomous driving device, comprising an on-board cabinet, the on-board cabinet comprising: a cabinet body comprising an internal space; a shock absorbing assembly disposed in the internal space, the shock absorbing assembly comprising: an adjusting plate and an elastic element; a carrier plate disposed in the internal space; and a computing unit disposed on the carrier plate, wherein the adjusting plate is vertically disposed in the internal space by the elastic element, and the carrier plate is movably disposed on the adjusting plate.

Another aspect of the disclosed embodiments relates to a method, comprising: providing a cabinet body comprising an internal space; providing a shock absorbing assembly disposed in the internal space, the shock absorbing assembly comprising: an adjusting plate; and an elastic element; and providing a carrier plate disposed in the internal space; wherein the adjusting plate is vertically disposed in the internal space by the elastic element, and the carrier plate is movably disposed on the adjusting plate.

In some example embodiments, the method further comprises: providing a plurality of vertical columns, first connecting beams, and second connecting beams connected to each other; the vertical columns are arranged at intervals and arranged in two rows; wherein the vertical columns in each row are arranged along a first direction; the first connecting beams extend along the first direction and are arranged on upper parts and lower parts of the vertical columns, so that the vertical columns in a same row are connected, and the second connecting beams extend along a second direction and are arranged between the two rows of the vertical columns, so that the vertical columns in the two rows are connected. According to some example embodiments, two ends of each of the second connecting beams are respectively connected to the first connecting beams on the two rows of vertical columns. In certain example embodiments, the elastic element is vertically disposed on the cabinet body, and the adjusting plate is connected to the cabinet body by the elastic element and is vertically movable relative to the cabinet body to get close to or away from the cabinet body.

Those of ordinary skill in the art should understand that the above are only specific implementations of the present disclosure, but the protection scope of the present disclosure is not limited thereto. Obviously, those of ordinary skill in the art can make various changes and modifications to the present disclosure without departing from the scope of the present disclosure. In this way, if these modifications and variations of this present disclosure fall within the scope of the claims of this present disclosure and their equivalent technologies, this present disclosure is also intended to include these modifications and variations.

Implementations of the subject matter and the functional operations described in this patent document can be implemented in various systems, semiconductor devices, optical devices, digital electronic circuitry, or in computer software, firmware, or hardware, including the structures disclosed in this specification and their structural equivalents, or in combinations of one or more of them. Implementations of aspects of the subject matter described in this specification can be implemented as one or more computer program products, e.g., one or more modules of computer program instructions encoded on a tangible and non-transitory computer readable medium for execution by, or to control the operation of, data processing apparatus. The computer readable medium can be a machine-readable storage device, a machine-readable storage substrate, a memory device, a composition of matter effecting a machine-readable propagated signal, or a combination of one or more of them. The term "data processing unit" or "data processing apparatus" encompasses all apparatus, devices, and machines for processing data, including by way of example a programmable processor, a computer, or multiple processors or computers. The apparatus can include, in addition to hardware, code that creates an execution environment for the computer program in question, e.g., code that constitutes processor firmware, a protocol stack, a database management system, an operating system, or a combination of one or more of them.

A computer program (also known as a program, software, software application, script, or code) can be written in any form of programming language, including compiled or interpreted languages, and it can be deployed in any form, including as a stand-alone program or as a module, component, subroutine, or other unit suitable for use in a computing environment. A computer program does not necessarily correspond to a file in a file system. A program can be stored in a portion of a file that holds other programs or data (e.g., one or more scripts stored in a markup language document), in a single file dedicated to the program in question, or in multiple coordinated files (e.g., files that store one or more modules, sub programs, or portions of code). A computer program can be deployed to be executed on one computer or on multiple computers that are located at one site or distributed across multiple sites and interconnected by a communication network.

The processes and logic flows described in this specification can be performed by one or more programmable processors executing one or more computer programs to perform functions by operating on input data and generating output. The processes and logic flows can also be performed by, and apparatus can also be implemented as, special purpose logic circuitry, e.g., an FPGA (field programmable gate array) or an ASIC (application specific integrated circuit).

Processors suitable for the execution of a computer program include, by way of example, both general and special purpose microprocessors, and any one or more processors of any kind of digital computer. Generally, a processor will receive instructions and data from a read only memory or a random-access memory or both. The essential elements of a computer are a processor for performing instructions and one or more memory devices for storing instructions and data. Generally, a computer will also include, or be operatively coupled to receive data from or transfer data to, or both, one or more mass storage devices for storing data, e.g., magnetic, magneto optical disks, or optical disks. However, a computer need not have such devices. Computer readable media suitable for storing computer program instructions and data include all forms of nonvolatile memory, media and memory devices, including by way of example semiconductor memory devices, e.g., EPROM, EEPROM, and flash memory devices. The processor and the memory can be supplemented by, or incorporated in, special purpose logic circuitry.

While this patent document contains many specifics, these should not be construed as limitations on the scope of any invention or of what may be claimed, but rather as descriptions of features that may be specific to particular embodiments of particular inventions. Certain features that are described in this patent document in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. Moreover, the separation of various system components in the embodiments described in this patent document should not be understood as requiring such separation in all embodiments.

Only a few implementations and examples are described, and other implementations, enhancements and variations can be made based on what is described and illustrated in this patent document.

## Claims

1. An on-board cabinet, comprising:
a cabinet body comprising an internal space;
a shock absorbing assembly disposed in the internal space, the shock absorbing assembly comprising:
an adjusting plate; and
an elastic element; and
a carrier plate disposed in the internal space;
wherein the adjusting plate is vertically disposed in the internal space by the elastic element, and the carrier plate is movably disposed on the adjusting plate.

2. The on-board cabinet as claimed in claim 1, wherein the cabinet body comprises a plurality of vertical columns, first connecting beams, and second connecting beams connected to each other;
the vertical columns are arranged at intervals and arranged in two rows; wherein the vertical columns in each row are arranged along a first direction;
the first connecting beams extend along the first direction and are arranged on upper parts and lower parts of the vertical columns, so that the vertical columns in a same row are connected, and
the second connecting beams extend along a second direction and are arranged between the two rows of the vertical columns, so that the vertical columns in the two rows are connected.

3. The on-board cabinet as claimed in claim 2, wherein two ends of each of the second connecting beams are respectively connected to the first connecting beams on the two rows of vertical columns.

4. The on-board cabinet as claimed in claim 1, wherein the elastic element is vertically disposed on the cabinet body, and the adjusting plate is connected to the cabinet body by the elastic element and is vertically movable relative to the cabinet body to get close to or away from the cabinet body.

5. The on-board cabinet as claimed in claim 4, wherein the cabinet body comprises a plurality of positioning holes arranged vertically, and the elastic element is connected to the cabinet body through the positioning holes.

6. The on-board cabinet as claimed in claim 1, wherein the carrier plate comprises a plurality of carrier plates, and the plurality of carrier plates are sequentially arranged in the internal space along a first direction.

7. The on-board cabinet as claimed in claim 1, wherein the shock absorbing assembly comprises a plurality of shock absorbing assemblies, and the plurality of shock absorbing assemblies are sequentially arranged in the internal space along a periphery of the carrier plate.

8. The on-board cabinet as claimed in claim 1, further comprising an elastic support deposed at a bottom of the cabinet body, and the elastic support being configured to support the carrier plate when the carrier plate gets close to the bottom of the cabinet body.

9. The on-board cabinet as claimed in claim 1, further comprising a sliding rail extending in a first direction disposed on the adjusting plate, the carrier plate being connected to the sliding rail and being movable relative to the sliding rail.

10. An autonomous driving device, comprising an on-board cabinet according to any one of claims 1-9.

11. A vehicle, comprising an autonomous driving device according to claim 10.

12. A method, comprising:
providing a cabinet body comprising an internal space;
providing a shock absorbing assembly disposed in the internal space, the shock absorbing assembly comprising:
an adjusting plate; and
an elastic element; and
providing a carrier plate disposed in the internal space;
wherein the adjusting plate is vertically disposed in the internal space by the elastic element, and the carrier plate is movably disposed on the adjusting plate.

13. The method as claimed in claim 12, further comprising:
providing a plurality of vertical columns, first connecting beams, and second connecting beams connected to each other;
the vertical columns are arranged at intervals and arranged in two rows; wherein the vertical columns in each row are arranged along a first direction;
the first connecting beams extend along the first direction and are arranged on upper parts and lower parts of the vertical columns, so that the vertical columns in a same row are connected, and
the second connecting beams extend along a second direction and are arranged between the two rows of the vertical columns, so that the vertical columns in the two rows are connected.

14. The method as claimed in claim 13, wherein two ends of each of the second connecting beams are respectively connected to the first connecting beams on the two rows of vertical columns.

15. The method as claimed in claim 12, wherein the elastic element is vertically disposed on the cabinet body, and the adjusting plate is connected to the cabinet body by the elastic element and is vertically movable relative to the cabinet body to get close to or away from the cabinet body.
